# EUROPEAN PATENT SPECIFICATION

(11) **EP 2 825 008 B1**
(45) Date of publication and mention of the grant of the patent: **13.06.2018**
(21) Application number: 13175768.4
(22) Date of filing: 09.07.2013
(51) Int. Cl.: H05K 7/14, H05K 7/20

(54) **Oil cooling configuration for subsea converter**
Ölkühlungskonfiguration für Unterwasserumwandler
Configuration de refroidissement par huile pour convertisseur sous-marin

(43) Date of publication of application: 14.01.2015
(73) Proprietor: ABB Schweiz AG, 5400 Baden (CH)
(72) Inventor: Riedel, Gernot, CH-5406 Rütihof (CH); Kicin, Slavo, CH-8049 Zürich (CH); Gradinger, Thomas, CH-5032 Aarau Rohr (CH)
(74) Representative: Savela, Reino Aleksi

(56) References cited:
- EP-A1- 2 501 213
- EP-A1- 2 533 621
- DE-U1-202004 003 644
- GB-A- 1 600 095
- US-A- 4 302 793
- US-A1- 2007 267 741

## Description

### TECHNICAL FIELD

The present invention relates to an electric subsea converter system comprising a cooling system.

### BACKGROUND

Electric subsea installations and devices usually demand high standards regarding durability, long-term functionality and independence during operation. Electric installations that need to be cooled during operation, such as subsea converters, require an autonomous and durable cooling of its components. It is known to use a dielectric liquid such as a for example oil as cooling fluid. In general electric subsea installations need to be pressurized with the dielectric fluid, thus said fluid, which is preferably a liquid, should be, at least almost, incompressible. The dielectric liquid is used as a cooling medium and as an electric insulation medium of components placed in the electric installation against a housing, and against other electric equipment such as electric conductors and against other components.

Referring specifically to subsea converters there are some requirements that make the construction of a subsea converters quite difficult. Due to the high reliability that is usually required, and since it is not easy to modify and provide access for maintenance for the subsea converter or for the electric installation from the outside, normally specialized personnel is hired, which is expensive and complicated and which can lead to a long downtime of the electric converter.

Cooling systems for electric equipment and specifically for electric subsea converters, are used to cool down electric components, such as semiconductor modules, connections and capacitors. These components generate heat that needs to be dissipated by the cooling system. The cooling system of subsea converters are usually designed in a simple manner avoiding any unnecessary parts and mechanisms. Generally it is desirable to have passive cooling systems, thus cooling systems without any driven or powered parts, such as for example without pumps, to cool down the electric components. In some cases natural convection is used. Natural convection helps to avoid the use of a pump but it has a low efficiency. Cooling by natural convection uses the heat exchange between the cooling liquid and the surrounding sea water to generate circulation within the cooling system and thus within the electric installation and the subsea converter, respectively. Usually some kind of a heat exchanger is used to exchange heat between the sea water and the cooling liquid.

In general the outer sides of the housings of subsea converters, the heat exchangers and any other parts that are in contact with the sea water should stay below a surface temperature of around 30° C. Thus even under full operating load the surfaces of the housing, the heat exchanger and any other parts in contacts with the surroundings should be below said temperature value. If the temperature reaches values higher than around 30° C sea life, such as algae, plankton, mussels, corals or the like, will grow on the outer side of the subsea converter and the heat exchanger respectively, which increases the thermal resistance of the housing and the heat exchanger of the subsea converter. As a result, sea life builds up on and clogs the outer surfaces of the subsea converter, thereby forming a thermal insulation layer that reduces the capability to dissipate heat from the affected surfaces. Since not all electric components of the subsea converter have the same heat flux that needs to be dissipated when in use, the sea life growth on the outer side of the subsea converter can be uneven which leads to different thermal insulation values on the surface of the subsea converter, making it even more difficult to predict and calculate the heat dissipation and to determine the operating load of the electric converter.

Another problem that relates to the growth of sea life, specifically the growth of sea life on the heat exchanger, is the spacing of the fins of the heat exchanger. In order to avoid that the sea life completely blocks the circulation of sea water through the heat exchanger, the spacing between the fins that extend into the sea water, away from the subsea converter and its housing, needs to be chosen comparably large, thus reducing the efficiency of the heat exchanging process.

Conventional subsea converters are further comparably large, requiring a huge amount of dielectric liquid, such as oil, for the cooling system. Further, environmental laws or aspects may require that the smallest amount of oil possible is used.

US 2007/267741 A1 discloses a portable, self-contained liquid submersion cooling system that is suitable for cooling a number of electronic devices, including cooling heat-generating components in computer systems and other systems that use electronic, heat-generating components. The electronic device includes a housing having an interior space, a dielectric cooling liquid in the interior space, a heat-generating electronic component disposed within the space and submerged in the dielectric cooling liquid, and a pump for pumping the liquid into and out of the space, to and from a heat exchanger that is fixed to the housing outside the interior space. The heat exchanger includes a cooling liquid inlet, a cooling liquid outlet, and a flow path for cooling liquid therethrough from the cooling liquid inlet to the cooling liquid outlet.

EP 2'501'213 A1 discloses an energy conversion device, in particular for an electric drive system of an underwater compression and pumping station, comprising a power module, means for cooling the power module , and a sealed housing for accommodating the power module and at least part of the cooling means. The cooling means comprises a cooling circuit in which a coolant fluid circulates, a first heat exchanger with the power module, through which the coolant fluid from the cooling circuit passes, and at least one pump for driving the coolant fluid in circulation within the circuit.

Hence there is a need to improve the efficiency of the cooling system and the arrangement of modules in electric subsea converters.

### SUMMARY

One object of the present invention is to provide an improved electric converter system with an efficient cooling system and an optimized arrangement of modules.

In view of the above it is a particular object of the present invention to provide an electric converter system that is compact, powerful and versatile.

Disclosed herein is an electronic converter system, that comprises a housing configured to receive a dielectric fluid. The electric converter system further comprises at least one stackable electric module comprising a first section and a second section, a cooling system comprising a second heat exchanger in thermal connection with the fluid and a first fluid stream path being configured to receive a first fluid stream passing through the first section and the second heat exchanger. The electric converter system further comprises a second fluid stream path configured to receive a second fluid stream passing through the second section and the second heat exchanger, the second fluid stream having a flow rate that differs from that of the first fluid stream.

An electric converter system with the above indicated features has the advantage that different fluid streams can be used to cool down different components, which means that the fluid streams can be adapted to specific cooling requirements. The first fluid stream may for example have a higher flow rate than the second fluid stream, thus, in this example, the capacity of the first stream to cool down electric components arranged in the first section of the electric module may be higher than the capacity of the second fluid stream.

It is clear that third, fourth, fifth, etc. fluid stream paths and streams, respectively may be installed and used in the cooling system. The invention is not limited to a specific number of fluid stream paths and fluid streams respectively.

The fluid stream paths and the cooling system, respectively, are configured to be adapted to various heat dissipation requirements of various electric components and thus the flow rates of the correspondent fluid streams may differ from one another.

The cooling system may be driven by natural convection. This avoids the use of a pump or other driven mechanism to circulate the fluid. In this way the effect of a possible pump failure on the cooling system is avoided.

Advantageously the first section of the at least one stackable electric module may comprise a semiconductor element and an inter module bus portion. The second section may comprise a capacitor element. A first heat exchanger of the cooling system may be arranged in thermal connection with the semiconductor module.

The semiconductor module has normally a higher heat flux than the capacitor and thus the first heat exchanger is used to dissipate the heat away from the semiconductor element. The first fluid stream of the first fluid stream path is used to cool down the first heat exchanger element. Thus in the specific case the flow rate per cross section or the flow speed of the first stream is higher than the flow rate per cross section or the flow speed of the second stream flowing in the second stream path, since the capacitor element has a lower heat flux than the semiconductor element.

The semiconductor element may be an insulated gate bipolar transistor (IGBT), but not necessarily.

Modular multilevel converters (MMC) may be particularly suitable for subsea use, since they are reliable. MMCs are configured to provide redundant power modules or power cells. It is possible to arrange the power modules in rows and columns (stacks). The cooling system may be adapted to the arrangement of MMC power modules. It is possible to adapt the cooling system to the modularity of the power cells, meaning that the cooling system as a whole is modular. Thus the modules or stackable electric modules have a multilevel topology and the electric converter system may be a multilevel converter system.

In case MMCs are used, the cell capacitors and the IGBTs need to be cooled, thus the first fluid stream may be used to cool the IGBTs and the second fluid stream may be used to cool the cell capacitors.

In general the IGBTs or semiconductor elements have a high heat dissipation and thus a high heat flux but on the other hand they can operate at temperatures of up to 125°C. The capacitors have a lower power dissipation and a lower heat flux and their maximum temperature has to be kept rather low in order to have a long lifetime. The cooling system is configured to fulfil these requirements.

A modularity of the power modules and the cooling system may provide a high flexibility and versatility of the converter system and it enables an easy mounting of the power modules in the housing of the converter system.

The invention, however, is not limited to MMCs; any other suitable electric module or cell may fall within the scope of the present invention.

In an advantageous embodiment the cooling system comprises a third fluid stream path configured to receive a third fluid stream, said third fluid stream being configured to cool down the inter module bus bar portion.

It is possible to provide an electronic converter with an arbitrary number of fluid stream paths and thus fluid streams. Using a lot of fluid stream paths may however influence the size of the electric converter.

The dielectric fluid used may be oil and the electric converter may be configured for subsea use, thus preferably pressurized and sealed.

As already indicated while discussing the MMCs the electric converter may comprise a plurality of stackable electric power modules forming vertical stacks. The first section and the second section are arranged in series in respect to the first and second fluid stream and thus with the first and second fluid stream paths.

The semiconductor elements of one vertical stack may be arranged in series with the first fluid stream and the capacitor elements may be arranged in series with the second fluid stream. The first and second fluid streams and fluid stream paths may thus be oriented vertically in a region close to the stackable power modules.

It is possible to use a number of vertical stacks. According to one embodiment in the range of 3 to 18 stacks are used.

Advantageously the second heat exchanger may be configured to exchange heat between the dielectric fluid and the sea water in order to cool down the dielectric fluid. The second heat exchanger may have various configurations one of the many possible examples is given below.

At least one wall portion of the housing may be configured to form part of the second heat exchanger. At least one wall portion may comprise second heat exchanger fins protruding from an outer side of the wall portion and from an inner side of the wall portion into at least one of the first, second and third fluid stream path. Second heat exchanger fins protruding from the outer side of the wall portion, into the sea water, are configured to transfer heat to the sea water. The first, second, and third fluid streams may be guided together as one fluid stream when passing the second heat exchanger. Alternatively, the first, second, and third fluid streams may be separated when they pass through the second heat exchanger, whereby the number and size of the fins used for each of the first, second, and third fluid streams may be adapted to the temperature difference ΔT between the corresponding fluid stream and the sea water, thus improving the efficiency of the heat transfer. A higher temperature difference ΔT between two mediums leads to a higher heat transfer rate.

Advantageously the fluid streams comprising similar temperature differences ΔT in respect to the surrounding sea water or medium may be guided or bundled together when passing through the second heat exchanger. This may enhance the efficiency of the heat exchanging process and thus of the whole cooling system.

The cooling system used in an electronic converter according to the invention is designed, among others, to avoid the heating of electric components by other electronic components, which means that components arranged in the first space do not heat components arranged in the second space and additionally also neighbouring electric components do not heat each other. Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Fig. 1 shows a side view of a cross section of an electric converter system;
Fig. 2 shows a top down view onto an electric converter system according to figure 1, whereby a top cover of a housing of the converter system has been removed;
Fig. 3 shows a similar view as figure 1 of another embodiment of the electric converter system according to the invention;
Fig. 4 shows a top down view onto an electric converter system according to figure 3, whereby a top cover of the housing of the converter system has been removed;
Fig. 5 shows a similar view as in figure 3 of another embodiment of the electric converter system according to the invention; and
Fig. 6 shows a top down view of a cross section of the electric converter system according to figure 5.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description

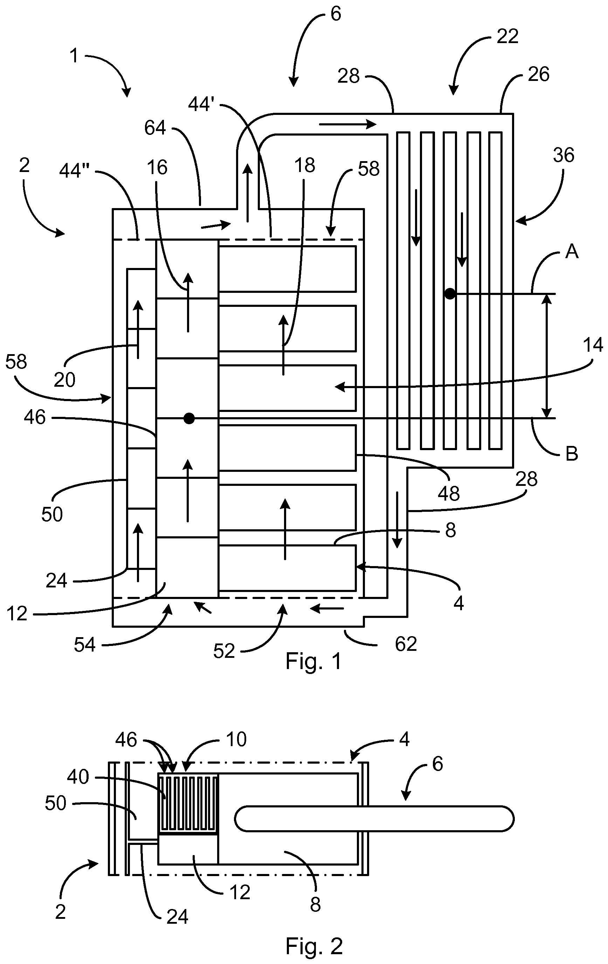

Reference is now made to figures 1 to 6. The electric converter 1 comprises a housing 2, stackable electric modules 4 and a cooling system 6. The stackable electric modules 4 are arranged in the housing 2. The stackable electric modules 4 may be MMCs as illustrated in the figures, but the electric modules 4 may not be limited to MMCs; other modules such as for example two-level converters, three-level converters or MMC variants may be used.

The stackable electric modules 4 are arranged in vertical stacks 58 forming a power module also known as power electronic building block (PEBB). The electric converter 1 is thus made up of plurality of vertical stacks 58. The number of vertical stacks 58 used can vary, which means that the electric converter 1 can be equipped depending on application needs such as for example requirements of the power grid. From the figures it becomes clear that the electric converter system is modular.

The stackable electric module 4 comprises a first section 54 and a second section 52 whereby the first and second section 54, 52 comprise various electric components. The first section 54 comprises an inter module bus bar portion 24, which is connected via terminals, and a semiconductor element 12 such as an insulated gate bipolar transistors (IGBT). The invention is however not limited to the use of IGBTs as semiconductor element, other semiconductor elements, such as a metal oxide semiconductor field effect transistor (MOSFET) fall within the scope of the invention. The second section 52 comprises a capacitor element 8. The capacitor element 8 can take up a lot of space, in some cases up to 80% of the volume of the stackable electric module 4.

The cooling system 6 comprises a fluid loop configuration 14, a second heat exchanger 22 and a first heat exchanger 10 and baffle elements 44. The fluid loop configuration 14 comprises a first fluid stream path 16 configured to receive and guide a first fluid stream, a second fluid stream path 18 configured to receive and guide a second fluid stream and a third fluid stream path 20 configured to receive and guide a third fluid stream. The first, second and third fluid stream paths 16, 18, 20 are configured to pass the first and second sections of a vertical stack 58 of stackable electric modules 4 in series. The fluid loop configuration 14 is thus configured to have a, at least more or less, vertical apophysis or branch that corresponds at least approximately to a height of the corresponding vertical stack 58 and that passes along and through the first and second section 54, 52 of the stackable electric modules 4 as illustrated in figures 1, 3 and 5. The vertical upwards apophysis or branch of the fluid loop configuration 14 comprises the first, second and third fluid stream paths 16, 18, 20, which pass through or along the first and second section 54, 52 as shown in the figures. In the figures the fluid in the fluid loop configuration 14 circulates clockwise. A counter-clockwise circulation of the fluid is also possible and falls within the scope of the invention.

The fluid that is used for cooling of the stackable electric modules 4 can be oil or any other suitable dielectric fluid such as for example liquid esters.

The electric converter shown in the figures is used for subsea applications. The second heat exchanger 22 is thus used to exchange heat energy between the fluid and the sea water.

The circulation of the fluid is driven by natural convection, which will now be illustrated referring to the figures, in particular to figures 1, 3 and 5. The fluid of the first, second, and third stream flows from the second heat exchanger 22, where it is cooled by heat exchange with sea water, via a fluid duct arrangement 28 to a bottom 62 part of the electric converter 1 and the housing 2, respectively. From the bottom 62 of the housing 2 the fluid flows in the first, second and third fluid stream paths in an at least more or less vertical direction upwards passing through and along the vertical stack 58 of stackable electric modules 4. During this vertical upwards flow the fluid is heated by heat absorption from the electronic and electrical components of the stackable electric modules 4, such as the semiconductor element 12, the capacitor element 8 and the inter-module bus bar portion 24. The first heat exchanger 10 is arranged in thermal connection with the semiconductor module 12. The semiconductor module 12 generates a high heat flux, which means a high amount of heat energy needs to be dissipated and the use of a first heat exchanger 10 improves the efficiency of the heat exchange between the fluid and the semiconductor element 12. The electric components of the stackable electric module 4 and the first and second heat exchanger 10, 22, drive the fluid circulation in the fluid loop configuration and the first, second, and third fluid stream paths 16, 18, 20, respectively, by natural convection.

In order to improve the circulation and thus the efficiency of the cooling system 6 it is possible to use a pump (not shown) to drive the circulation. The use of a pump or pumps to drive the cooling system 6 falls within the scope of the invention.

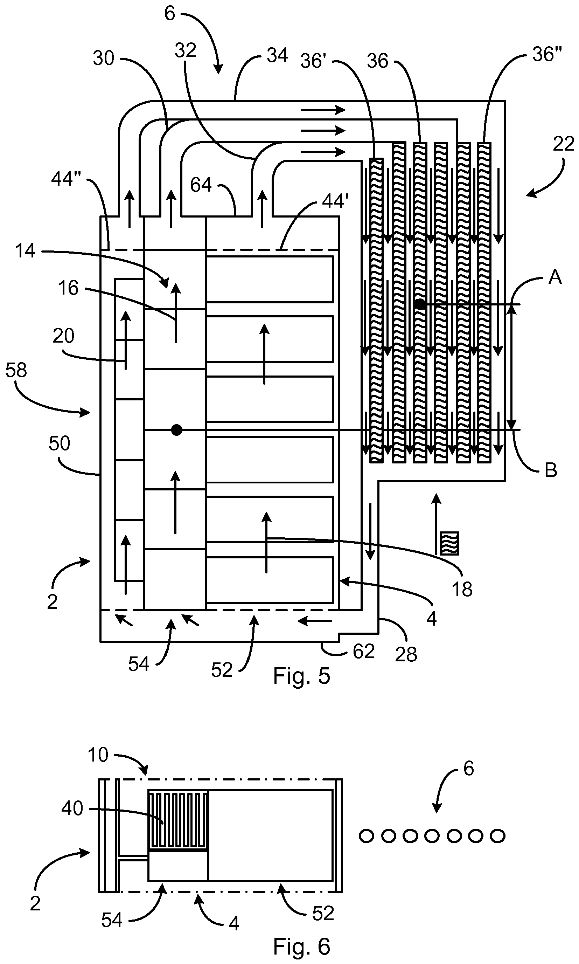

At the bottom 62 part of the housing the fluid stream is separated into the first, second and third fluid stream. Guiding means arranged in bottom 62 (not shown) may be used to divide the fluid stream in the first, second and third fluid stream. The first and second sections 54, 52 may comprise fluid ducts 46, 48, 50, whereby a plurality of fluid ducts from several stackable electric modules 4 may form the fluid stream paths as illustrated in the figures. In general the fluid ducts may be made of an electric insulating, dielectric material. The capacitor element 8 may comprise a second fluid duct 48, whereby the second fluid ducts 48 of a vertical stack 58 form at least a part of one of the vertical apophysis' or branches of the second fluid stream path 18. The semiconductor element 12 may comprise a first fluid duct 46, whereby the first fluid ducts 46 of a vertical stack 58 form at least a part of one of the vertical apophysis' or branches of the first fluid stream path 16. The inter module bus bar portion 24 may comprise a third fluid duct 50, whereby the third fluid ducts 50 of a vertical stack 58 form at least a part of one of the vertical apophysis' or branches of the third fluid stream path 20. It is possible to keep the first, second and third fluid stream paths 16, 18, 20 and thus the first, second and third fluid streams at least more or less separate all the way through the vertical upwards apophysis or branch and through the second heat exchanger 22 as illustrated in figures 5 and 6. It may also be possible to arrange the fluid stream paths and thus the fluid streams so that the first, second and third fluid streams join each other at a top 64 of the housing 2 as illustrated in figures 1 to 4.

The second heat exchanger 22 is arranged on the vertical downwards apophysis or branch of the fluid circulation. The second heat exchanger 22 can comprise a plurality of tube or pipe bundles 36, 36', 36" where the fluid, such as the oil, can circulate, transfer heat to the sea water and thus cool down.

Figures 1, 2, 5 and 6 illustrate an electric converter system 1 comprising a second heat exchanger 22 with at least one fluid tube bundle 36 fluidically connected to the first, second and third fluid stream paths 16, 18, 20.

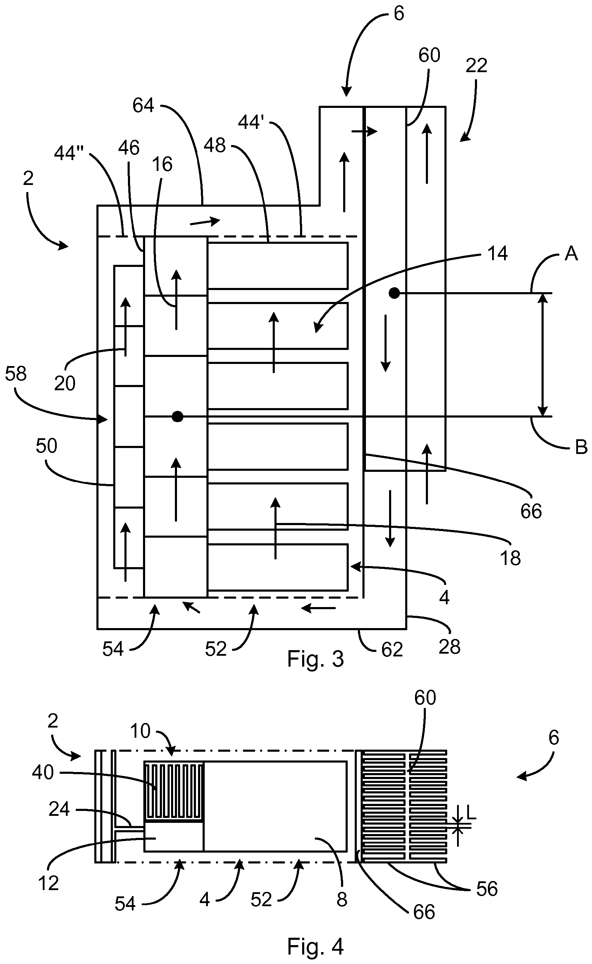

Figures 3 and 4 illustrate an electric converter system whereby a wall portion 60 of the housing 2 forms part of the second heat exchanger 22. From the wall portion 60 a plurality of second heat exchanger fins 56 protrude on an outer side of the wall portion 60 away from the wall portion 60 and the housing 2, respectively, in the installed state of the electric subsea converter 1 into the sea water, and on a inner side of the wall portion 60 into the inside of the housing 2. The dielectric cooling fluid is configured to flow through the second heat exchanger fins 56, which protrude on the inside of the housing 2 and the sea water is supposed to flow through the second heat exchanger fins 56, which protrude on the outside of the housing 2, thereby allowing an efficient heat exchange between the fluid and the sea water. The distance L as illustrated in figure 4, between the second heat exchanger fins 56 on the outer side of the housing 2 is chosen in order to avoid a build-up of sea life with resultant clogging of water flow and to generate a high enough flow of sea water so that sea life has difficulty to grow. According to one embodiment L is at least 15 mm.
In the embodiment according to figures 3 and 4 the first, second and third fluid streams are united when they flow through second heat exchanger 22, as best seen in figure 4. It is however possible and falls within the scope of the invention to separate the first, second and third fluid streams with according guiding means (not shown) so that the first, second and third streams are guided separately through the second heat exchanger 22 and only united when they flow out of the second heat exchanger 22. Advantages of such a separation of the fluid streams will be discussed below in relation to the embodiment of figures 5 and 6. In case the first, second and third fluid streams are guided separately through the second heat exchanger 22 it is even possible to adapt the length of the second heat exchanger fins 56, at least on the outer side of the housing 2 to specific cooling needs, e.g. installing longer fins for the fluid streams having a higher temperature difference ΔT compared to the surrounding sea water. In the present case, most likely the fluid in the first fluid stream has the highest temperature difference ΔT to the surrounding sea water, since the semiconductor modules 12 generate a high amount of heat energy and thus a high heat flux on their surface. In the embodiments of figures 3 and 4 there is a thermal insulation wall 66 acting as a guiding sheet provided between the second heat exchanger 22 and the inside of the housing 2 to avoid the heat exchange between fluid of the second stream and fluid in the second heat exchanger 22 and in order to guide the fluid circulation of the fluid streams.

The first heat exchanger 10 as best illustrated in figures 2, 4 and 6 comprises first heat exchanger fins 40 that enable an efficient heat exchange between the semiconductor module 12 and the fluid in the first fluid stream path 16. The first heat exchanger fins 40 and the space between the first heat exchanger fins 40, respectively, may form the first fluid duct 46, in which the first fluid stream may flow.

The space in between the inter module bus bar portions 24 may form the third fluid duct 50.

Turning to figures 1, 2, 5 and 6 which show another configuration of a second heat exchanger 22, and where the first, second and third fluid streams join each other at a top portion 64 of the housing 2. According to the embodiment of figure 1 the housing 2 comprises a first heat exchanger portion 26 that comprises the fluid duct arrangement 28. At the top 64 of the housing 2, the first, second and third fluid streams are guided as one stream into the fluid duct arrangement 28. The fluid duct arrangement 28 comprises the fluid tube bundle 36 which is exposed to the surrounding sea water. The fluid stream flows through fluid tube bundle 36 and cools down by exchanging heat energy between the sea water and the fluid via the wall of the tubes of the fluid tube bundle 36. From the fluid tube bundle 36 the fluid stream flows via a connection tube of the fluid arrangement 28 to a bottom part 62 of the housing 2 where the fluid stream is divided into first, second and third fluid streams in order to enter the first, second and third fluid ducts 46, 48, 50. The vertical upwards apophysis and vertical downwards apophysis of the fluid circulation loop or the fluid loop configuration 14 have different center of gravities A, B in order to make sure that the dielectric fluid is moved and that it circulates, driven by natural convection.

As can be seen from the figures the center of gravity A, B of the vertical upwards apophysis or branch and of the vertical downwards apophysis or branch differ in all embodiments.

Referring now specifically to the embodiment according to figures 5 and 6, the second heat exchanger 22 may comprise a plurality of fluid tube bundles 36, 36', 36". The first, second and third fluid streams do not join each other at a top 64 or close to a top 64 of the housing 2. The first, second and third fluid streams are kept separate at the top 62 and guided into corresponding first fluid tube 30, second fluid tube 32 and third fluid tube 34. The first, second and third fluid tubes 30, 32, 34 keep the first, second and third fluid stream separate from one another and guide them into the corresponding first fluid tube bundle 36, second fluid tube bundle 36' and third fluid tube bundle 36". Since the semiconductor modules 12 most likely generate the highest amount of heat energy, the fluid from the first stream will have the highest temperature difference ΔT compared to the surrounding sea water. The number of tubes forming the first tube bundle 36 may thus be higher than the number of tubes forming the second or third tube bundles 36', 36". The sizes of the fluid tube bundles 36, 36', 36" may thus vary and also the according heat exchanging rates, since the heat exchange surface may also vary.

Using separate heat exchanger portions or fluid tube bundles 36, 36', 36" for the first, second and third streams allows to bundle fluid streams with similar temperature differences ΔT in the second heat exchanger 22 so that the efficiency of the heat energy exchange (heat exchange rate) in the second heat exchanger 22 is improved. In addition, using separate first, second and third fluid tube bundles 36, 36' 36" allows to adapt the build-up of the second heat exchanger 22 to the fluid volume per unit time contained in each of the first, second and third fluid stream. The capacitor elements 8 for instance do not require a very fast and strong cooling but the volume of second fluid stream, which cools the capacitor elements 8 and which flows through the second fluid stream path 18, is high. Other components having a comparably low heat flux during operation, such as for example gate drives, control electronics may be cooled by the second or third fluid stream.

The first, second and third fluid streams may be only partly joined together, for example if the second and third stream comprise fluid with a similar temperature difference ΔT these two fluid streams may be guided together at the top part 64 of the housing 2, whereas the first fluid stream is kept separate and guided separately in the first heat exchanger 22 because of a higher or lower temperature difference ΔT. Thus the invention allows providing various solutions for the electric converter system and for the cooling system 6 of the electric converter system 1, respectively.

In order to properly insulate the stackable electric modules 4 from the one another, there is a gap arranged in between each neighbouring stackable electric module 4, the gap being filled with dielectric fluid, in order to electrically insulate the stackable electric modules 4 from the other modules. Further, between each vertical stack 58 and the housing 2 of the electric converter there is a space provided, said space being configured to receive dielectric fluid for electric insulation purposes.

The baffle elements 44 as illustrated in figures 1, 3 and 5 are used to regulate the fluid flow rate in the first, second and third fluid stream. The baffle elements 44, 44', 44" can be arranged at the end of the vertical upwards apophysis of the fluid loop configuration 14. One single baffle element 44 or a plurality of baffle elements 44, 44', 44", as illustrated in the figures, may be used. The baffle elements 44, 44', 44" can be configured to be automatically controlled, for example depending on parameters measured in the fluid flow or fluid loop configuration 14. One baffle element 44 may be configured to control the fluid flow in the first fluid stream, another baffle element 44' may be configured to control the fluid flow in the second fluid stream and still another baffle element 44" may be configured to control the fluid flow in the third fluid stream. Alternatively one baffle element 44 may be used for all the fluid streams.

The baffle elements 44, 44', 44" may be arranged close to the bottom part 62 of the housing 2 and/or close to the top 64 of the housing 2. The baffle elements 44, 44', 44" may be grills or nets with different sizes of openings or just flaps that open and close over the first, second and third fluid stream, respectively.

There may be only one baffle element 44 installed, said baffle element 44 regulating only one flow rate of the various flow streams. The number of installed baffle elements 44 may be adapted to the cooling requirements and performance of the cooling system 6.

It is possible to include the control of the baffle elements 44, 44', 44" into a control cycle that measures the temperatures of the fluid in the different fluid streams and for example the surface temperature of the electric components of the stackable electric modules 4 and decides whether or not to open or close the baffle elements 44, 44', 44" to adjust the speed/flow rate of the first, second and/or third fluid stream. This could optimize the cooling of the electric converter.

The baffle elements 44, 44', 44" may be arranged close to the bottom 62 and/or close to the top 64 of the housing 2. As is readily appreciated by a person skilled in the art, other embodiments than the ones disclosed above are equally possible within the scope of the invention, as defined by the appended patent claims.

## Claims

1. Subsea electronic converter system (1), comprising
a housing (2) configured to receive a dielectric fluid,
at least one stackable electric module (4) arranged in the housing (2), the at least one stackable electric module (4) comprising a first section (54) and a second section (52),
a cooling system (6) comprising a second heat exchanger (22) in thermal connection with the fluid, the second heat exchanger (22) being configured to exchange heat between the dielectric fluid and sea water, a first fluid stream path (16) being configured to receive a first fluid stream passing through the second heat exchanger (22) and the first section (54) to cool the first section (54), and a second fluid stream path (18) configured to receive a second fluid stream passing through the second heat exchanger (22) and the second section (52) to cool the second section (52), the second fluid stream having a flow rate that differs from that of the first fluid stream,
wherein the second heat exchanger comprises a fluid tube bundle (36) configured to receive the first and the second fluid stream paths and configured to transfer heat energy from the fluid to sea water, and
wherein the fluid tube bundle (36) comprises a first and a second separate fluid tube bundle (36, 36'), and wherein each of the first, and the second fluid stream paths is in fluid connection with one of the separate first and second fluid tube bundles (36, 36').

2. The subsea electronic converter system according to claim 1, wherein the cooling system comprises a first heat exchanger (10) arranged in the first section of the at least one stackable electric module.

3. The subsea electronic converter system (1) according to claim 1 or 2,
wherein the cooling system is configured to be driven by natural convection.

4. The subsea electronic converter system (1) according to any claims 1 to 3, wherein the first section of the at least one stackable electric module comprises a semiconductor element (12) and an inter module bus bar portion (24), and wherein the second section comprises a capacitor element (8).

5. The subsea electronic converter system (1) according to claim 2, wherein the first heat exchanger is in thermal connection with the semiconductor element and wherein the first fluid stream is configured to cool down the first heat exchanger.

6. The subsea electronic converter system (1) according to claim 4 and 5, wherein the second fluid stream is configured to cool down the capacitor element.

7. The subsea electronic converter system (1) according to any of claims 4, 5 or 6, wherein the cooling system comprises a third fluid stream path (20) configured to receive a third fluid stream said third fluid stream being configured to cool down the inter module bus bar portion.

8. The subsea electronic converter system (1) according to any of the preceding claims, wherein the dielectric fluid is oil.

9. The subsea electronic converter system (1) according to any of the preceding claims, comprising a plurality of stackable electric power modules forming vertical stacks (58) and wherein the first section and the second section are arranged in series in respect to the first and second fluid stream paths.

10. The subsea electronic converter system (1) according to claim 9, wherein the vertical stacks of stackable electric modules are arranged side-by-side and wherein a number of vertical stacks can be chosen depending on application requirements.

11. The subsea electronic converter system (1) according to claim 7, wherein the cooling system comprises a baffle element (44) configured to regulate at least one of the flow rates of the first fluid stream path, the second fluid stream path and, the third fluid stream path.

12. The subsea electronic converter system (1) according to claim 7 or 11, wherein the fluid tube bundle (36) further is configured to receive the third fluid stream paths.

13. The subsea electronic converter system (1) according to claim 12, wherein each of the first, second and third fluid stream paths is in fluid connection with one of the separate fluid tube bundles (36, 36', 36").

14. The subsea electronic converter system (1) according to any of the claims 1 to 11, wherein at least one wall portion (60) of the housing is configured to form part of the second heat exchanger, the at least one wall portion comprising second heat exchanger fins (56) protruding from an outer side of the wall portion and from an inner side of the wall portion into at least one of the first, second and third fluid stream path.

15. The subsea electronic converter system (1) according to any of the preceding claims, wherein the first section comprises a first fluid duct (46), and wherein the second section comprises a second fluid duct (48), said fluid ducts being configured to guide the first and second fluid streams, respectively.

## Patentansprüche

1. Elektronisches Unterwasserwandlersystem (1), umfassend:
ein Gehäuse (2), das gestaltet ist, ein dielektrisches Fluid aufzunehmen,
mindestens ein stapelbares elektrisches Modul (4), das im Gehäuse (2) angeordnet ist, wobei das mindestens eine stapelbare elektrische Modul (4) einen ersten Abschnitt (54) und einen zweiten Abschnitt (52) umfasst,
ein Kühlungssystem (6), das einen zweiten Wärmetauscher (22) in thermischer Verbindung mit dem Fluid, wobei der zweite Wärmetauscher (22) gestaltet ist, Wärme zwischen dem dielektrischen Fluid und Meerwasser auszutauschen, einen ersten Fluidströmungspfad (16), der gestaltet ist, einen ersten Fluidstrom aufzunehmen, der durch den zweiten Wärmetauscher (22) und den ersten Abschnitt (54) strömt, um den ersten Abschnitt (54) zu kühlen, und
einen zweiten Fluidströmungspfad (18), der gestaltet ist, einen zweiten Fluidstrom aufzunehmen, der durch den zweiten Wärmetauscher (22) und den zweiten Abschnitt (52) strömt, um den zweiten Abschnitt (52) zu kühlen, umfasst, wobei der zweite Fluidstrom eine Strömungsrate hat, die sich von jener des ersten Fluidstroms unterscheidet,
wobei der zweite Wärmetauscher ein Fluidrohrbündel (36) umfasst, das gestaltet ist, den ersten und den zweiten Fluidströmungspfad aufzunehmen, und gestaltet ist, Wärmeenergie vom Fluid zum Meerwasser zu übertragen, und
wobei das Fluidrohrbündel (36) ein erstes und ein zweites separates Fluidrohrbündel (36, 36') umfasst und wobei jeder von dem ersten und dem zweiten Fluidstrompfad mit einem der separaten ersten und zweiten Fluidrohrbündel (36, 36') in strömungstechnischer Verbindung ist.

2. Elektronisches Unterwasserwandlersystem nach Anspruch 1, wobei das Kühlungssystem einen ersten Wärmetauscher (10) umfasst, der im ersten Abschnitt des mindestens einen stapelbaren elektrischen Moduls angeordnet ist.

3. Elektronisches Unterwasserwandlersystem (1) nach Anspruch 1 oder 2, wobei das Kühlungssystem gestaltet ist, durch natürliche Konvektion angetrieben zu werden.

4. Elektronisches Unterwasserwandlersystem (1) nach einem der Ansprüche 1 bis 3, wobei der erste Abschnitt des mindestens einen stapelbaren elektrischen Moduls ein Halbleiterelement (12) und ein Intermodul-Sammelschienenteil (24) umfasst und wobei der zweite Abschnitt ein Kondensatorelement (8) umfasst.

5. Elektronisches Unterwasserwandlersystem (1) nach Anspruch 2, wobei der erste Wärmetauscher in thermischer Verbindung mit dem Halbleiterelement ist und wobei der erste Fluidstrom gestaltet ist, den ersten Wärmetauscher abzukühlen.

6. Elektronisches Unterwasserwandlersystem (1) nach Anspruch 4 und 5, wobei der zweite Fluidstrom gestaltet ist, das Kondensatorelement abzukühlen.

7. Elektronisches Unterwasserwandlersystem (1) nach einem der Ansprüche 4, 5 oder 6, wobei das Kühlungssystem einen dritten Fluidströmungspfad (20) umfasst, der gestaltet ist, einen dritten Fluidstrom aufzunehmen, wobei der dritte Fluidstrom gestaltet ist, das Intermodul-Sammelschienenteil abzukühlen.

8. Elektronisches Unterwasserwandlersystem (1) nach einem der vorangehenden Ansprüche, wobei das dielektrische Fluid Öl ist.

9. Elektronisches Unterwasserwandlersystem (1) nach einem der vorangehenden Ansprüche, umfassend mehrere stapelbare elektrische Leistungsmodule, die vertikale Stapel (58) bilden, und wobei der erste Abschnitt und der zweite Abschnitt in Serie in Bezug auf den ersten und zweiten Fluidströmungspfad angeordnet sind.

10. Elektronisches Unterwasserwandlersystem (1) nach Anspruch 9, wobei die vertikalen Stapel stapelbarer elektrischer Leistungsmodule Seite an Seite angeordnet sind und wobei eine Anzahl vertikaler Stapel abhängig von Anwendungsanforderungen gewählt werden kann.

11. Elektronisches Unterwasserwandlersystem (1) nach Anspruch 7, wobei das Kühlungssystem ein Leitblechelement (44) umfasst, das gestaltet ist, mindestens eine der Strömungsraten des ersten Fluidströmungspfads, des zweiten Fluidströmungspfads und des dritten Fluidströmungspfads zu regulieren.

12. Elektronisches Unterwasserwandlersystem (1) nach Anspruch 7 oder 11, wobei das Fluidrohrbündel (36) ferner gestaltet ist, die dritten Fluidströmungspfade aufzunehmen.

13. Elektronisches Unterwasserwandlersystem (1) nach Anspruch 12, wobei jeder der ersten, zweiten und dritten Fluidströmungspfade mit einem der separaten Fluidrohrbündel (36, 36', 36") in strömungstechnischer Verbindung ist.

14. Elektronisches Unterwasserwandlersystem (1) nach einem der Ansprüche 1 bis 11, wobei mindestens ein Wandteil (60) des Gehäuses gestaltet ist, einen Teil des zweiten Wärmetauschers zu bilden, wobei das mindestens eine Wandteil zweite Wärmetauscherlamellen (56) umfasst, die von einer Außenseite des Wandteils und von einer Innenseite des Wandteils in mindestens einen des ersten, zweiten und dritten Fluidströmungspfads abstehen.

15. Elektronisches Unterwasserwandlersystem (1) nach einem der vorangehenden Ansprüche, wobei der erste Abschnitt einen ersten Fluidkanal (46) umfasst und wobei der zweite Abschnitt einen zweiten Fluidkanal (48) umfasst, wobei die Fluidkanäle gestaltet sind, den ersten bzw. zweiten Fluidstrom zu leiten.

## Revendications

1. Système de convertisseur électronique sous-marin (1), comprenant
un boîtier (2) configuré pour recevoir un fluide diélectrique,
au moins un module électrique empilable (4) disposé dans le boîtier (2), l'au moins un module électrique empilable (4) comprenant une première section (54) et une deuxième section (52),
un système de refroidissement (6) comprenant un deuxième échangeur de chaleur (22) en communication thermique avec le fluide, le deuxième échangeur de chaleur (22) étant configuré pour échanger de la chaleur entre le fluide diélectrique et l'eau de mer, un premier passage de fluide (16) étant configuré pour recevoir un premier courant de fluide traversant le deuxième échangeur de chaleur (22) et la première section (54) pour refroidir la première section (54), et un deuxième passage de fluide (18) configuré pour recevoir un deuxième courant de fluide traversant le deuxième échangeur de chaleur (22) et la deuxième section (52) pour refroidir la deuxième section (52), le deuxième courant de fluide ayant un débit qui diffère de celui du premier courant de fluide,
dans lequel le deuxième échangeur de chaleur comprend un faisceau de tubes de fluide (36) configuré pour recevoir les premier et deuxième passages de fluide et configuré pour transférer de l'énergie thermique du fluide à l'eau de mer, et
dans lequel le faisceau de tubes de fluide (36) comprend des premier et deuxième faisceaux de tubes de fluide séparés (36, 36'), et dans lequel chacun des premier et deuxième passages de fluide est en communication fluidique avec un des premier et deuxième faisceaux de tubes de fluide séparés (36, 36').

2. Système de convertisseur électronique sous-marin selon la revendication 1, dans lequel le système de refroidissement comprend un premier échangeur de chaleur (10) disposé dans la première section de l'au moins un module électrique empilable.

3. Système de convertisseur électronique sous-marin (1) selon la revendication 1 ou 2, dans lequel le système de refroidissement est configuré pour être activé par convection naturelle.

4. Système de convertisseur électronique sous-marin (1) selon l'une quelconque des revendications 1 à 3, dans lequel la première section de l'au moins un module électrique empilable comprend un élément semi-conducteur (12) et une portion de barre de distribution intermodule (24), et dans lequel la deuxième section comprend un élément condensateur (8).

5. Système de convertisseur électronique sous-marin (1) selon la revendication 2, dans lequel le premier échangeur de chaleur est en communication thermique avec l'élément semi-conducteur et dans lequel le premier courant de fluide est configuré pour refroidir le premier échangeur de chaleur.

6. Système de convertisseur électronique sous-marin (1) selon la revendication 4 et 5, dans lequel le deuxième courant de fluide est configuré pour refroidir l'élément condensateur.

7. Système de convertisseur électronique sous-marin (1) selon l'une quelconque des revendications 4, 5 ou 6, dans lequel le système de refroidissement comprend un troisième passage de fluide (20) configuré pour recevoir un troisième courant de fluide, ledit troisième courant de fluide étant configuré pour refroidir la portion de barre de distribution intermodule.

8. Système de convertisseur électronique sous-marin (1) selon l'une quelconque des revendications précédentes, dans lequel le fluide diélectrique est une huile.

9. Système de convertisseur électronique sous-marin (1) selon l'une quelconque des revendications précédentes, comprenant une pluralité de modules électriques empilables formant des empilements verticaux (58) et dans lequel la première section et la deuxième section sont disposées en série par rapport aux premier et deuxième passages de fluide.

10. Système de convertisseur électronique sous-marin (1) selon la revendication 9, dans lequel les empilements verticaux de modules électriques empilables sont disposés côte à côte et dans lequel un nombre d'empilements verticaux peut être choisi en fonction d'exigences d'application.

11. Système de convertisseur électronique sous-marin (1) selon la revendication 7, dans lequel le système de refroidissement comprend un élément déflecteur (44) configuré pour réguler au moins un des débits du premier passage de fluide, du deuxième passage de fluide et du troisième passage de fluide.

12. Système de convertisseur électronique sous-marin (1) selon la revendication 7 ou 11, dans lequel le faisceau de tubes de fluide (36) est également configuré pour recevoir les troisièmes passages de fluide.

13. Système de convertisseur électronique sous-marin (1) selon la revendication 12, dans lequel chacun des premier, deuxième et troisième passages de fluide est en communication fluidique avec un des faisceaux de tubes de fluide séparés (36, 36', 36").

14. Système de convertisseur électronique sous-marin (1) selon l'une quelconque des revendications 1 à 11, dans lequel au moins une portion de paroi (60) du boîtier et configurée pour former une partie du deuxième échangeur de chaleur, l'au moins une portion de paroi comprenant des ailettes de deuxième échangeur de chaleur (56) faisant saillie depuis un côté externe de la portion de paroi et depuis un côté interne de la portion de paroi jusqu'à l'intérieur d'au moins un des premier, deuxième et troisième passage de fluide.

15. Système de convertisseur électronique sous-marin (1) selon l'une quelconque des revendications précédentes, dans lequel la première section comprend un premier conduit de fluide (46), et dans lequel la deuxième section comprend un deuxième conduit de fluide (48), lesdits conduits de fluide étant configurés pour guider les premier et deuxième courants de fluide, respectivement.
